# EUROPEAN PATENT APPLICATION

(11) **EP 4 401 153 A2**
(43) Date of publication of application: **17.07.2024**
(21) Application number: 24178575.7
(22) Date of filing: 28.05.2024
(51) Int. Cl.: H01L 31/068, H01L 31/0747, H01L 31/0216

(54) **SOLAR CELL AND MANUFACTURING METHOD THEREOF, PHOTOVOTAIC MODULE, AND PHOTOVOTAIC SYSTEM**

(30) Priority: 22.11.2023 CN 202311561364
(71) Applicant: Trina Solar Co., Ltd, Changzhou, Jiangsu 213031 (CN)
(72) Inventor: LIU, Chengfa, CHANGZHOU 213031 (CN); CHEN, Hong, CHANGHZOU 213031 (CN); CHEN, Daming, CHANGZHOU 213031 (CN); WANG, Zigang, CHANGZHOU 213031 (CN); LIU, Wei, CHANGZHOU 213031 (CN)
(74) Representative: Arnold & Siedsma

(57) **Abstract**

The present application relates to a solar cell and a manufacturing method thereof, a photovoltaic module, and a photovoltaic system. The solar cell (200) includes a substrate (40) and a passivated contact structure (100). The passivated contact structure (100) includes a first tunnel oxide layer (10), a polysilicon doped conductive layer (30), and a second tunnel oxide layer (20) sequentially disposed on a surface of the substrate (40). A plurality of holes (50) arranged spaced apart from each other are formed in at least a part of regions of the polysilicon doped conductive layer (30) and the first tunnel oxide layer (10). Each of the holes (50) extends through the polysilicon doped conductive layer (30) and extends into the first tunnel oxide layer (10). The second tunnel oxide layer (20) at least fills a portion of each of the holes that is located within the first tunnel oxide layer (10).

## Description

### TECHNICAL FIELD

The present application relates to the field of photovoltaic technology, and in particularly, to a solar cell and a manufacturing method thereof, a photovoltaic module, and a photovoltaic system.

### BACKGROUND

With continuous development of photovoltaic technologies, people have increasingly higher requirements for the photovoltaic conversion efficiency of crystalline silicon solar cells. However, at present, there are still many challenges to improve the efficiency of industrial solar cells. In a solar cell in a related art, in order to reduce a recombination rate, prolong a minority carrier lifetime, and improve photoelectric conversion efficiency of the solar cell, passivation processing is generally performed on a silicon substrate to form a passivated contact structure on a surface of the silicon substrate, so as to reduce the recombination of surface carriers, thereby reducing effects of internal defects of the silicon substrate. In a conventional passivated contact structure, a tunnel oxide layer is combined with a heavily doped polysilicon layer, and an interface recombination between the silicon substrate and the polysilicon is reduced by means of chemical passivation effect of the tunnel oxide layer. In addition, the tunnel oxide layer may also perform a relatively good tunneling function, so that most carriers are transported according to a tunneling principle, while a few carriers are recombined because they are difficult to tunnel into the polysilicon layer through the tunnel oxide layer due to a relatively high barrier. However, in the solar cell in the related art, a problem that the passivated contact structure has a discontinuous structure and poor integrity often exists, which causes a poor surface passivation effect of the passivated contact structure, and affects the conversion efficiency of the solar cell.

### SUMMARY

According to various embodiments, a solar cell and a manufacturing method thereof, a photovoltaic module, and a photovoltaic system are provided.

A first aspect of embodiments of the present application provides a solar cell. The solar cell includes a substrate and a passivated contact structure;
the passivated contact structure includes a first tunnel oxide layer, a polysilicon doped conductive layer, and a second tunnel oxide layer sequentially disposed on a surface of the substrate;
a plurality of holes arranged spaced apart from each other are formed in at least a part of regions of the polysilicon doped conductive layer and the first tunnel oxide layer, and each of the holes extends through the polysilicon doped conductive layer and extends into the first tunnel oxide layer; and
the second tunnel oxide layer at least fills a portion of each of the holes that is located within the first tunnel oxide layer.

In one of the embodiments, the second tunnel oxide layer fully fills each of the holes.

In one of the embodiments, at least a part of the holes extends through the first tunnel oxide layer.

In one of the embodiments, a cross-sectional profile of the hole is in a circular shape, and a diameter of the hole is greater than or equal to 100 nm; or
a cross-sectional profile of the hole is in a shape of polygon, and a length of at least one edge of the polygon is greater than or equal to 100 nm.

In one of the embodiments, a thickness of the first tunnel oxide layer is equal to a thickness of the second tunnel oxide layer; and/or
the first tunnel oxide layer is made of a same material as the second tunnel oxide layer.

In one of the embodiments, a thickness of the second tunnel oxide layer is in a range from 0.5 nm to 5 nm.

In one of the embodiments, the polysilicon doped conductive layer includes a first polysilicon doped conductive layer and a second polysilicon doped conductive layer that are laminated;
the first polysilicon doped conductive layer is adjacent to the first tunnel oxide layer, and the second polysilicon doped conductive layer is adjacent to the second tunnel oxide layer; and
a doping concentration of the first polysilicon doped conductive layer is lower than a doping concentration of the second polysilicon doped conductive layer.

In one of the embodiments, a reflectivity of the first surface of the substrate is greater than 30%; and/or
a roughness of the first surface of the substrate is less than 1 µm; and
the first surface is a surface of the substrate on which the first tunnel oxide layer is disposed.

In one of the embodiments, the solar cell further includes:
a first passivation film layer laminated on a surface of the second tunnel oxide layer that is away from the substrate; and
a doped conductive layer and a second passivation film layer, sequentially laminated on a surface of the substrate that is away from the first tunnel oxide layer.

A second aspect of embodiments of the present application provides a manufacturing method of a solar cell, which includes:
sequentially forming and laminating a first tunnel oxide layer and a polysilicon doped conductive layer on a surface of the substrate; where, a plurality of holes arranged spaced apart from each other are formed in at least a part of regions of the polysilicon doped conductive layer and the first tunnel oxide layer, and each of the holes extends through the polysilicon doped conductive layer and extends into the first tunnel oxide layer; and
forming a second tunnel oxide layer on a surface of the polysilicon doped conductive layer that is away from the first tunnel oxide layer, and the second tunnel oxide layer at least filling a portion of each of the holes that is located within the first tunnel oxide layer.

In one of the embodiments, the sequentially forming and laminating the first tunnel oxide layer and the polysilicon doped conductive layer on the surface of the substrate specifically includes:
sequentially forming a first tunnel oxide material layer, a polysilicon doped material layer, and a first oxide material layer on a first surface of the substrate, where a plurality of through holes are formed in the polysilicon doped material layer and the first oxide material layer, such that regions of the first tunnel oxide material layer corresponding to the through holes are exposed; and
removing the first tunnel oxide material layer, the polysilicon doped material layer, and the first oxide material layer that are plated around a second surface of the substrate and each of side surfaces of the substrate, to sequentially form the first tunnel oxide layer, the polysilicon doped conductive layer, and a first oxide layer on the first surface of the substrate; where the first surface and the second surface are arranged opposite to each other, and each of the side surfaces of the substrate is adjacent to and located between the first surface and the second surface; and
removing the first oxide layer, and removing at least a part of regions of the first tunnel oxide layer corresponding to the through holes in a thickness direction of the first tunnel oxide layer, so as to define the holes together with the corresponding through holes.

In one of the embodiments, the sequentially forming the first tunnel oxide material layer, the polysilicon doped material layer, and the first oxide material layer on the first surface of the substrate specifically includes:
sequentially forming a first tunnel oxide material layer, an amorphous silicon doped material layer, and a first oxide material layer on the first surface of the substrate; and
performing an annealing process to transform the amorphous silicon doped material layer into the polysilicon doped material layer, and forming the plurality of through holes in the polysilicon doped material layer and the first oxide material layer.

In one of the embodiments, a process condition of the annealing process includes:
increasing a reaction temperature from 25°C to a first preset temperature at a rate greater than 5°C/min, and maintaining for a preset time period, where the first preset temperature is greater than 600°C;
decreasing the reaction temperature from the first preset temperature to a second preset temperature at a rate greater than 2°C/min, where the second preset temperature is less than the first preset temperature and greater than 600°C; and
decreasing the reaction temperature from the second preset temperature to a third preset temperature at a rate greater than 20°C/min, where the third preset temperature is less than 100°C.

In one of the embodiments, the forming the amorphous silicon doped material layer includes:
sequentially forming and laminating a first amorphous silicon material layer and a second amorphous silicon material layer on a surface of the first tunnel oxide material layer that is away from the substrate, where an effective electroactive doping concentration of the first amorphous silicon material layer is less than an effective electroactive doping concentration of the second amorphous silicon material layer.

In one of the embodiments, the effective electroactive doping concentration of the first amorphous silicon material layer is less than 2E20cm⁻³ , and the effective electroactive doping concentration of the second amorphous silicon material layer is greater than or equal to 2E20cm⁻³.

In one of the embodiments, the forming the second tunnel oxide layer on the surface of the polysilicon doped conductive layer that is away from the first tunnel oxide layer includes:
forming the second tunnel oxide layer on the surface of the polysilicon doped conductive layer that is away from the first tunnel oxide layer, and the second tunnel oxide layer fully filling the holes.

In one of the embodiments, the manufacturing method further includes: before the sequentially forming and laminating the first tunnel oxide layer and the polysilicon doped conductive layer on the surface of the substrate,
performing etching processing on a first surface of the substrate, such that a reflectivity of the first surface is greater than 30%; and/or
   performing etching processing on the first surface of the substrate, such that a roughness of the first surface of the substrate is less than 1 µm; and
where, the first surface is a surface of the substrate on which the first tunnel oxide layer is disposed.

In one of the embodiments, the manufacturing method further includes: after the forming the second tunnel oxide layer on the surface of the polysilicon doped conductive layer that is away from the first tunnel oxide layer,
forming a first passivation film layer on a surface of the second tunnel oxide layer that is away from the substrate.

A third aspect of embodiments of the present application provides a photovoltaic module. The photovoltaic module includes at least one cell string. The cell string includes at least two above solar cells.

A fourth aspect of embodiments of the present application provides a photovoltaic system. The photovoltaic system includes the above photovoltaic module.

The above solar cell and the manufacturing method thereof, the photovoltaic module, and the photovoltaic system have advantageous effects as follows.

In the embodiments of the present application, the second tunnel oxide layer is disposed, and the second tunnel oxide layer at least fills the portion of each of the holes that is located within the first tunnel oxide layer. As such, the regions, that is, discontinuous regions, of the first tunnel oxide layer corresponding to the holes, can be filled with the second tunnel oxide layer, and regions on the surface of the substrate corresponding to the holes can also be covered by the second tunnel oxide layer. Compared with a solution of a related art in which a passivated contact structure is not continuous and has a relatively poor passivation effect in the hole regions, the solution of the present application can improve the quality of surface passivation, reduce surface recombination, and improve the conversion efficiency of the solar cell.

### BRIEF DESCRIPTION OF THE DRAWINGS

FIG. 1 is a schematic view of a solar cell according to an embodiment of the present application.
FIG. 2 is a schematic view of a solar cell according to another embodiment of the present application.
FIG. 3 is a flow chart of a manufacturing method of a solar cell according to an embodiment of the present application.
FIG. 4 is a schematic view of a substrate of which a first surface is etched in the manufacturing method of the solar cell according to an embodiment of the present application.
FIG. 5 is a schematic view of a first tunnel oxide material layer, a polysilicon doped conductive material layer, and a first oxide material layer formed on the first surface of the substrate in the manufacturing method of the solar cell according to an embodiment of the present application.
FIG. 6 is a schematic view of a first tunnel oxide layer and a polysilicon doped conductive layer formed on the first surface of the substrate in the manufacturing method of the solar cell according to an embodiment of the present application.
FIG. 7 is a scanning electron microscopy photograph of holes formed in the manufacturing method of the solar cell according to an embodiment of the present application.
FIG. 8 is a microscope image of holes formed in the manufacturing method of the solar cell according to an embodiment of the present application.
FIG. 9 is a schematic view of a second tunnel oxide layer formed in the manufacturing method of the solar cell according to an embodiment of the present application.
FIG. 10 is a schematic view of a solar cell formed in the manufacturing method of the solar cell according to an embodiment of the present application.

Illustration For Reference Numerals:
100: passivated contact structure;
10: first tunnel oxide layer; 11: first tunnel oxide material layer; 20: second tunnel oxide layer; 30: polysilicon doped conductive layer; 301: polysilicon doped material layer; 302: first oxide material layer; 303: through hole; 31: first polysilicon doped conductive layer; 32: second polysilicon doped conductive layer; 40: substrate; 50: hole; 60: doped conductive layer; 70: first passivation film layer; 80: second passivation film layer; 91: first electrode; 92: second electrode;
200: solar cell;
F: first surface; S: second surface.

### DETAILED DESCRIPTION OF THE EMBODIMENTS

In order to make the above objects, features and advantages of the present application more apparent and better understood, embodiments of the present application will be fully described hereinafter with reference to the accompanying drawings. In the following description, many specific details are explained in order to fully understand the present application. However, the present application can be implemented in many other ways than those described herein, and such modifications may be made by those skilled in the art without departing from the scope of the present application, which is therefore not to be limited to the specific embodiments disclosed below.

In the description of the present application, it should be understood that the orientation or positional relationship indicated by terms "center", "longitudinal", "transverse", "length", "width", "thickness", "upper", "lower", "front", "rear", "left", "right", "vertical", "horizontal", "top", "bottom", "inner", "outer", "clockwise", "counterclockwise", "axial", "radial", "circumferential", and the like, is based on the orientation or positional relationship shown in the drawings, only to facilitate the description of the present application and simplify the description, rather than indicating or implying the device or elements must have a specific orientation, be constructed and operated in a specific orientation, and therefore cannot be construed as limitation of the present application.

In addition, the terms "first" and "second" are used for purposes of description only, and cannot be understood to indicate or imply relative importance or implicitly indicate the number of technical features indicated. Therefore, the features defined by "first" and "second" may explicitly or implicitly include at least one of the features. In the description of the present application, the "plurality" means at least two, such as two, three, or more, unless otherwise clearly and specifically defined.

In the present application, unless otherwise clearly specified and defined, terms such as "mounting", "coupling", "connection", "fixation" and others should be understood in a broad sense, for example, which can be a fixed connection or a detachable connection, or integrally formed; or can be a mechanical connection or an electrical connection; or can be a direct connection or an indirect connection through an intermediate medium; or can be an internal connection between two elements or an interaction between two elements, unless otherwise specified defined. For those of ordinary skill in the art, the specific meanings of the above terms in the present application can be understood according to specific circumstances.

In the present application, unless otherwise expressly stated and limited, a first feature being "on" or "below" a second feature may mean that the first feature is in direct contact with the second feature, or the first feature is in undirect contact with the second feature through an intermediate medium. Furthermore, a first feature being "over", "above" and "on" a second feature may mean that the first feature is directly above or obliquely above the second feature, or simply means that the first feature is higher in level than the second feature. A first feature being "below", "under" and "beneath" a second feature may mean that the first feature is directly below or obliquely below the second feature, or simply means that the first feature is lower in level than the second feature.

It should be noted that when an element is referred to as being "fixed to" or "disposed on" another element, it can be directly on the other element or an intermediate element may also be present. When an element is referred to as being "connected" to another element, it can be directly connected to the other element or there may also be an intermediate element. The terms "vertical", "horizontal", "upper", "lower", "left", "right" and similar expressions used herein are for illustrative purposes only and do not represent the unique implementations.

A solar cell and a manufacturing method thereof, a photovoltaic module, and a photovoltaic system of embodiments of the present application will be described below with reference to the accompanying drawings. The solar cell and the manufacturing method thereof, the photovoltaic module, and the photovoltaic system of embodiments of the present application can improve a surface passivation effect of the passivated contact structure, reduce surface recombination, and improve conversion efficiency of the solar cell.

It should be noted that in this application, the solar cell is a tunnel oxide passivated contact (TOPCon) is used as an example for description. The solar cell may also be other types of solar cell, which is the same as the solar cell of the present application, and details thereof are not repeatedly described herein again.

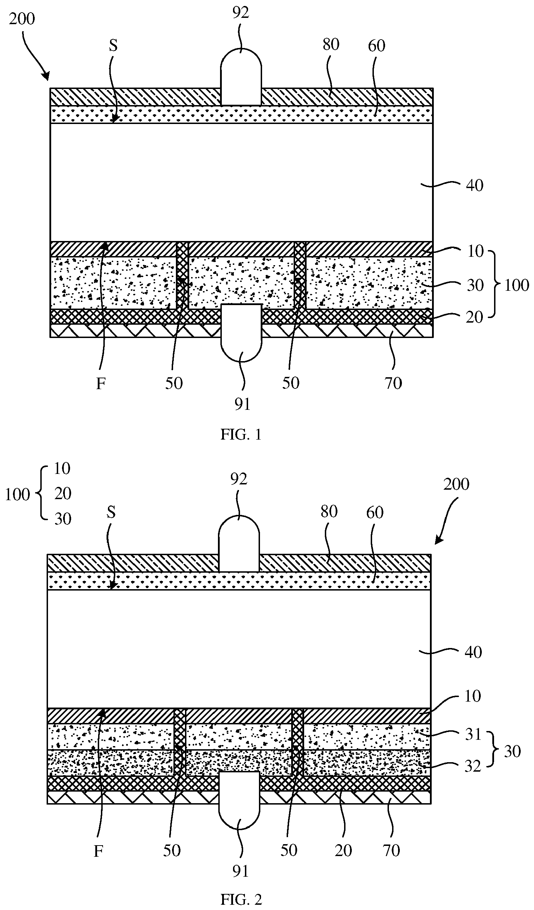

FIG. 1 is a schematic view of a solar cell according to an embodiment of the present application. FIG. 2 is a schematic view of a solar cell according to another embodiment of the present application.

Referring to FIGS. 1 and 2, a first aspect of embodiments of the present application provides a solar cell 200. The solar cell 200 includes a substrate 40 and a passivated contact structure 100. The passivated contact structure 100 includes a first tunnel oxide layer 10, a polysilicon doped conductive layer 30, and a second tunnel oxide layer 20 that are sequentially disposed on a surface of the substrate 40.

A plurality of holes 50 arranged spaced apart from each other are formed in at least a part of the regions of the polysilicon doped conductive layer 30 and the first tunnel oxide layer 10. Each of the holes 50 extends through the polysilicon doped conductive layer 30 and extends into the first tunnel oxide layer 10. The second tunnel oxide layer 20 at least fills the portion of each of the holes 50 that is located within the first tunnel oxide layer 10.

In the solar cell 200 in this embodiment of the present application, the second tunnel oxide layer 20 is disposed, and the second tunnel oxide layer 20 at least fills the portion of each of the holes 50 that is located within the first tunnel oxide layer 10. As such, the regions, that is, the discontinuous regions, of the first tunnel oxide layer 10 corresponding to the holes 50 can be filled with the second tunnel oxide layer 20, and regions on the surface of the substrate 40 corresponding to the holes 50 can also be covered by the second tunnel oxide layer 20. Compared with a solution of a related art in which a passivated contact structure is not continuous and has a relatively poor passivation effect in the hole regions, the solution of the present application can improve the quality of surface passivation, reduce surface recombination, and improve the conversion efficiency of the solar cell 200.

The first tunnel oxide layer 10, the polysilicon doped conductive layer 30, and the second tunnel oxide layer 20 being sequentially disposed on the surface of the substrate 40 means that the first tunnel oxide layer 10 is disposed on a surface of the substrate 40, the polysilicon doped conductive layer 30 is disposed on a surface of the first tunnel oxide layer 10 facing away from the substrate 40, and the second tunnel oxide layer 20 is disposed on a surface of the polysilicon doped conductive layer 30 facing away from the first tunnel oxide layer 10. However, silicon substrate flaws and discontinuous portions in the first tunnel oxide layer 10 caused by the holes 50 can be filled with a part of the material of the second tunnel oxide layer 20.

In addition, the positions of the plurality of holes 50 on the polysilicon doped conductive layer 30 and the first tunnel oxide layer 10 are randomly arranged, and for example, may be distributed within a local region, or may be distributed throughout the entire arrangement range of the polysilicon doped conductive layer 30 and the first tunnel oxide layer 10. Each of the holes 50 may include a first hole segment located within the polysilicon doped conductive layer 30 and a second hole segment located within the first tunnel oxide layer 10.

The second tunnel oxide layer 20 at least filling the portion of each of the holes 50 that is located within the first tunnel oxide layer 10 means that, among all the holes 50, the second hole segments thereof located within the first tunnel oxide layer 10 are covered by the second tunnel oxide layer 20. In other words, the material of the second tunnel oxide layer 20 filled in each of the holes 50 needs to completely cover the second hole segments of the holes 50 that are located within the first tunnel oxide layer 10. Based on this, a part of the material of the second tunnel oxide layer 20 may further fill the first hole segments of the holes 50 that are located within the polysilicon doped conductive layer 30.

In some embodiments, the second tunnel oxide layer 20 fully fills each of the holes 50. In this way, the second tunnel oxide layer 20 can also form a film layer with relatively good integrity and continuity, and the portions of the substrate 40 corresponding to the holes 50 can have a better passivation effect.

In an embodiment of the present application, at least some of the holes 50 extends through the first tunnel oxide layer 10. The surface of the substrate 40 is partially exposed via the holes 50. Since the second tunnel oxide layer 20 fully fills the holes 50, the second tunnel oxide layer 20 can directly get in contact with the portions of the substrate 40 corresponding to the holes 50, thereby greatly enhancing the passivation effect at these portions.

In an embodiment of the present application, a cross-sectional profile of the hole 50 is in a circular shape, and a diameter of the hole 50 is greater than or equal to 100 nm. Alternatively, a cross-sectional profile of the hole 50 is in a shape of polygon, and a length of at least one edge of the polygon is greater than or equal to 100 nm.

In this way, the polysilicon doped conductive layer 30 has a discontinuous structure. It may be understood that said polygon herein may be a regular or irregular polygon.

In an embodiment of the present application, a thickness of the first tunnel oxide layer 10 is equal to a thickness of the second tunnel oxide layer 20. And/or, the first tunnel oxide layer 10 is made of the same material as the second tunnel oxide layer 20.

Since the thickness of the first tunnel oxide layer 10 is equal to the thickness of the second tunnel oxide layer 20, it can be ensured that when the second tunnel oxide layer 20 fills the holes 50, the second tunnel oxide layer 20at least fully fills the second hole segments of the holes 50 that are located within the first tunnel oxide layer 10.

Specifically, the second hole segment of each of the holes 50 that is located within the first tunnel oxide layer 10 is filled with a part of the material of the second tunnel oxide layer 20. The first tunnel oxide layer 10 and the second tunnel oxide layer 20 have the same thickness range, and made of the same material, so that both the first tunnel oxide layer 10 and the second tunnel oxide layer 20 can form an ultra-thin oxide layer, and uniformity and consistency of performance among positions of the first tunnel oxide layer 10 can be ensured. The first tunnel oxide layer 10 and the second tunnel oxide layer 20 may be made of dielectric materials, for example, the dielectric materials may be at least one of silicon oxide, silicon carbide, silicon nitride, or silicon oxynitride.

Further, the thickness of the second tunnel oxide layer 20 is in a range from 0.5 nm to 5 nm, and the thickness of the first tunnel oxide layer 10 may also be in a range from 0.5 nm to 5 nm.

In an embodiment of the present application, in order to reduce an impact of a dopant on the first tunnel oxide layer 10 in a process of forming the polysilicon doped conductive layer 30, it is considered that the polysilicon doped conductive layer 30 is configured to have a multi-layer structure, and that a part of the layer structure of the polysilicon doped conductive layer 30 adjacent to the first tunnel oxide layer 10 is configured to have a lower doping concentration.

In a specific implementation, referring to FIG. 2, the polysilicon doped conductive layer 30 includes a first polysilicon doped conductive layer 31 and a second polysilicon doped conductive layer 32 that are laminated.

The first polysilicon doped conductive layer 31 is adjacent to the first tunnel oxide layer 10, and the second polysilicon doped conductive layer 32 is adjacent to the second tunnel oxide layer 20. A doping concentration of the first polysilicon doped conductive layer 31 is lower than a doping concentration of the second polysilicon doped conductive layer 32.

In this way, on the one hand, impact on the first tunnel oxide layer 10, brought by forming the second polysilicon doped conductive layer 32 with a relatively high doping concentration can be alleviated, and on the other hand, the first polysilicon doped conductive layer 31 with a relatively low doping concentration can have a higher hydrogen content, thereby assisting the first tunnel oxide layer 10 to achieve better surface passivation.

In a specific implementation, for example, the first polysilicon doped conductive layer 31 may also include a plurality of polysilicon doped sub-layers (not shown). The plurality of polysilicon doped sub-layers are laminated sequentially along a direction from the substrate 40 to the second tunnel oxide layer 20, with the doping concentrations increasing sequentially along such direction.

In an embodiment of the present application, with reference to FIG. 1 and FIG. 2, the substrate 40 may include a first surface F and a second surface S that are opposite to each other, and may further include a plurality of side surfaces adjacent to and located between the first surface F and the second surface S. The first surface F may correspond to a back surface or a front surface of the solar cell 200. The second surface S may correspond to a front surface or a back surface of the solar cell 200. In an embodiment of the present application, an example in which the first surface F corresponds to a back surface of the solar cell 200, and the first tunnel oxide layer 10 is disposed on the first surface F of the substrate 40 is used for description.

Further, a reflectivity of the first surface F of the substrate 40 is greater than 30%. Preferably, the reflectivity thereof is 38%, 40%, 42%, or 45%.

Further, a roughness of the first surface F of the substrate 40 is less than 1 µm.

In this way, the first surface F of the substrate 40 may be configured as a polished surface, so that the first surface F of the substrate 40 can have fewer silicon substrate flaws, thereby easily obtaining a better surface passivation effect.

Further, the solar cell 200 further includes a first passivation film layer 70, a doped conductive layer 60, a second passivation film layer 80, a first electrode 91, and a second electrode 92.

The first passivation film layer 70 is laminated on a surface of the second tunnel oxide layer 20 that is away from the substrate 40. The first passivation film layer 70 may adopt a single-layer or multi-layer structure. The first passivation film layer 70 may be made of silicon oxide, silicon nitride, or silicon oxynitride. With development of the technology of the solar cell 200, the back surface of the solar cell 200 may also receive energy of solar light, which is mainly reflected light or scattered light in the surrounding environment. The first passivation film layer 70 may include, for example, at least one first anti-reflection layer (not shown). In this way, reflectivity of the solar light on the back surface of the solar cell 200 can be reduced, and absorptivity of the solar light on the back surface of the solar cell 200 can be improved, so that the first passivation film layer 70 plays roles in both passivation and anti-reflection.

The doped conductive layer 60 and the second passivation film layer 80 are sequentially laminated on a surface of the substrate 40 that is away from the first tunnel oxide layer 10.

In an actual case, the solar cell 200 may include an N type cell or a P type cell. The N type cell includes the substrate 40 doped with an N type element, and the doped conductive layer 60 doped with a P type element. The P type cell includes the substrate 40 doped with an P type element, and the doped conductive layer 60 doped with an N type element. The doped conductive layer 60 is configured to form a PN junction with the substrate 40. In an embodiment of the present application, an example in which the substrate 40 is an N-type substrate is used for description. In this case, the doped conductive layer 60 may be P type doped, for example, may be a doped conductive layer 60 doped with a boron element. The doped conductive layer 60 doped with the boron element is also referred to as a P+ type emitter.

The second passivation film layer 80 is laminated on the doped conductive layer 60. The second passivation film layer 80 plays roles in surface passivation and anti-reflection in the solar cell 200. Therefore, dangling bonds on the surface of the substrate 40 can be better chemically passivated, and an anti-reflection effect can be achieved on a front surface of the solar cell 200.

As an example, the second passivation film layer 80 may include a second passivation layer (not shown) and a second anti-reflection layer (not shown) that are sequentially laminated on the doped conductive layer 60.

The second anti-reflection layer is located on the second surface S of the substrate 40, that is, on a surface on which the solar cell 200 receives incident light. The surface on which the solar cell 200 receives incident light is also referred to as a front surface or a light receiving surface. The second anti-reflection layer plays an anti-reflection effect on the front surface of the solar cell 200. The second anti-reflection layer may adopt a multi-layer structure. In the second anti-reflection layer of the multi-layer structure, each of the layers may be made of silicon oxide, silicon nitride, or silicon oxynitride.

The second passivation layer may adopt a single-layer structure or a multi-layer structure. The second passivation layer may be made of at least one of aluminium oxide, silicon oxide, silicon nitride, or silicon oxynitride. In addition, the second passivation layer may be formed by chemical deposition.

In addition, the first electrode 91 is disposed on the first passivation film layer 70, and is connected to the polysilicon doped conductive layer 30. The second electrode 92 is disposed on the second passivation film layer 80, and is connected to the doped conductive layer 60.

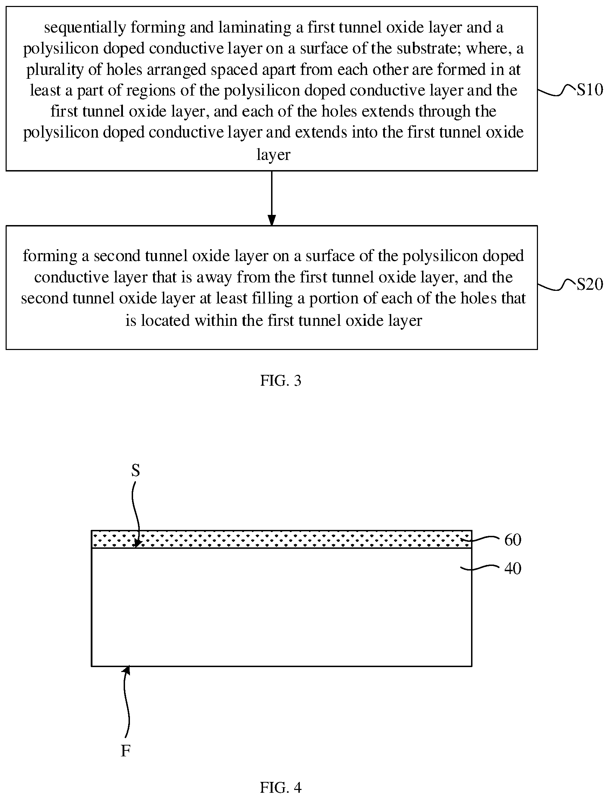

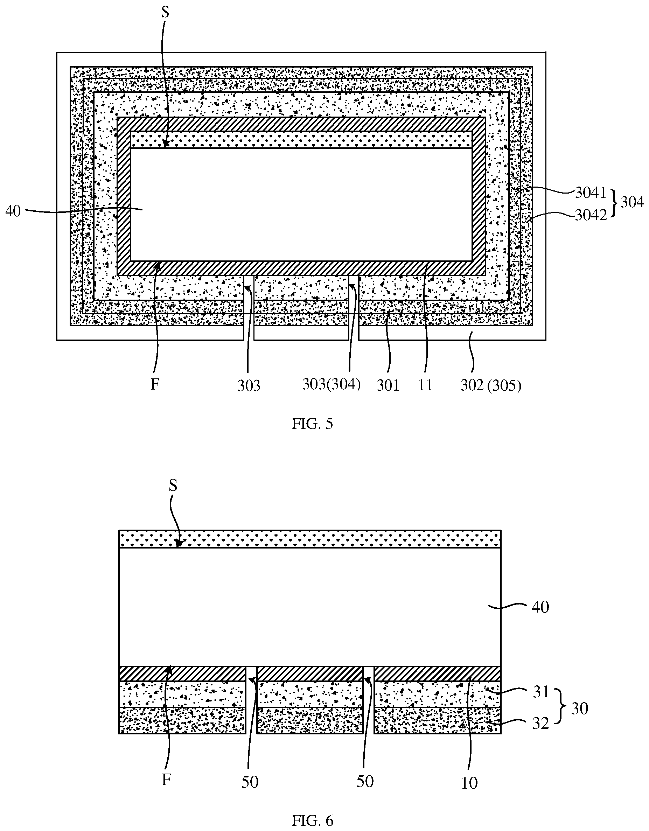

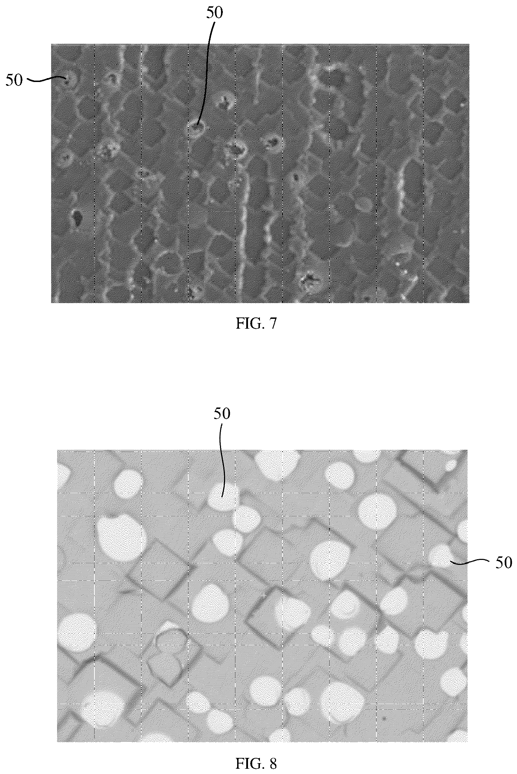

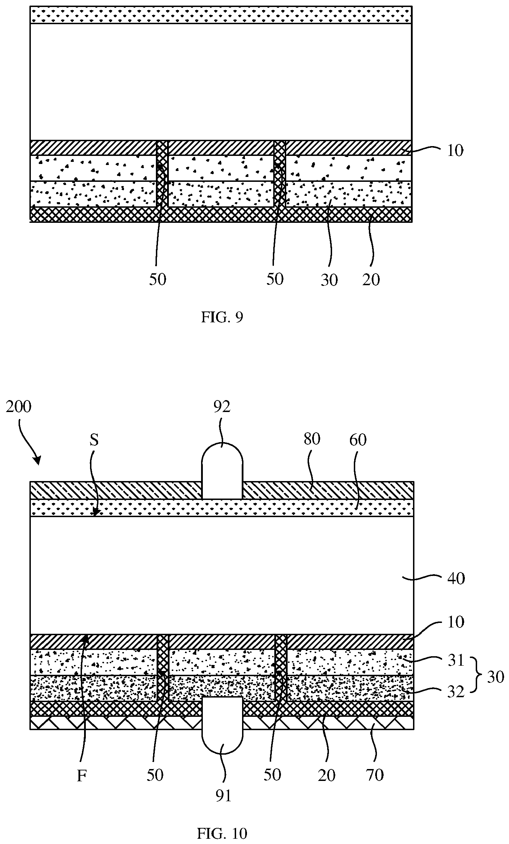

FIG. 3 is a flow chart of a manufacturing method of a solar cell according to an embodiment of the present application. FIG. 4 is a schematic view of a substrate of which a first surface is etched in the manufacturing method of the solar cell according to an embodiment of the present application. FIG. 5 is a schematic view of a first tunnel oxide material layer, a polysilicon doped conductive material layer, and a first oxide material layer formed on the first surface of the substrate in the manufacturing method of the solar cell according to an embodiment of the present application. FIG. 6 is a schematic view of a first tunnel oxide layer and a polysilicon doped conductive layer formed on the first surface F of the substrate in the manufacturing method of the solar cell according to an embodiment of the present application. FIG. 7 is a scanning electron microscopy photograph of holes formed in the manufacturing method of the solar cell according to an embodiment of the present application. FIG. 8 is a microscope image of holes formed in the manufacturing method of the solar cell according to an embodiment of the present application. FIG. 9 is a schematic view of a second tunnel oxide layer formed in the manufacturing method of the solar cell according to an embodiment of the present application. FIG. 10 is a schematic view of a solar cell formed in the manufacturing method of the solar cell according to an embodiment of the present application.

Referring to FIG. 3, a second aspect of embodiments of the present application provides a manufacturing method of a passivated contact structure. The solar cell 200 described in the foregoing embodiments can be manufactured by using this manufacturing method.

The manufacturing method of the solar cell includes steps of S10 to S10.

At S10, a first tunnel oxide layer 10 and a polysilicon doped conductive layer 30 are sequentially formed and laminated on a surface of a substrate 40. A plurality of holes 50 arranged spaced apart from each other are formed in at least a part of regions of the polysilicon doped conductive layer 30 and the first tunnel oxide layer 10. Each of the holes 50 extends through the polysilicon doped conductive layer 30 and extends into the first tunnel oxide layer 10.

At S20, a second tunnel oxide layer 20 is formed on a surface of the polysilicon doped conductive layer 30 that is away from the first tunnel oxide layer 10, and the second tunnel oxide layer 20 at least fills a portion of each of the holes 50 that is located within the first tunnel oxide layer 10.

The second tunnel oxide layer 20 is formed on the surface of the polysilicon doped conductive layer 30 that is away from the first tunnel oxide layer 10, and the second tunnel oxide layer 20 at least fills the portion of each of the holes 50 that is located within the first tunnel oxide layer 10. As such, the regions of the surface of the substrate 40 and the first tunnel oxide layer 10 that correspond to the holes 50 can be covered by or filled with the second tunnel oxide layer 20. Compared with a solution of a related art in which the structure is not continuous and a passivation effect in the hole regions is relatively poor, the solution of the present application can improve the quality of surface passivation, reduce surface recombination, and improve the conversion efficiency of the solar cell.

The inventors of the present application had also tested the solution in which the second tunnel oxide layer 20 fills the holes 50. Compared with the solution in which the holes are not covered by the tunnel oxide layer, in the present application, the open circuit voltage Uoc is changed from 728 mV to 729 mV. It can be learned that the performance of the solar cell 200 manufactured by using the manufacturing method of the embodiments of the present application is improved to a certain extent.

In an embodiment of the present application, referring to FIG. 1, the step of sequentially forming and laminating the first tunnel oxide layer 10 and the polysilicon doped conductive layer 30 on the surface of the substrate 40 in step S10 specifically includes steps of S11 to S13.

At S11, a first tunnel oxide material layer 11, a polysilicon doped material layer 301, and a first oxide material layer 302 are sequentially formed on a first surface F of the substrate 40. A plurality of through holes 303 are formed in the polysilicon doped material layer 301 and the first oxide material layer 302, such that regions of the first tunnel oxide material layer 11 corresponding to the through holes 303 are exposed, as shown in FIG. 5.

At S12, referring to FIG. 6, the first tunnel oxide material layer 11, the polysilicon doped material layer 301, and the first oxide material layer 302 that are plated around the second surface S of the substrate 40 and each of the side surfaces of the substrate 40 are removed, to sequentially form the first tunnel oxide layer 10, the polysilicon doped conductive layer 30, and a first oxide layer 305 on the first surface F of the substrate 40.

At S13, the first oxide layer 305 is removed, and at least a part of regions of the first tunnel oxide layer 10 corresponding to the through holes 303 in a thickness direction of the first tunnel oxide material layer 11 is removed, so as to define the holes 50 together with the corresponding through holes 303.

Further, the step of sequentially forming the first tunnel oxide material layer 11, the polysilicon doped material layer 301, and the first oxide material layer 302 on the first surface F of the substrate 40 in step S11 specifically includes steps of S111 to S112.

At S111, a first tunnel oxide material layer 11, an amorphous silicon doped material layer 304, and a first oxide material layer 302 are sequentially formed on the first surface F of the substrate 40.

At S112, an annealing process is performed to transform the amorphous silicon doped material layer 304 into the polysilicon doped material layer 301. The plurality of through holes 303 are formed in the polysilicon doped material layer 301 and the first oxide material layer 302.

Further, a process condition of the annealing process in step S112 includes:
increasing a reaction temperature from a room temperature (for example, about 25°C) to a first preset temperature at a rate greater than 5°C/min, and maintain for a preset time period (for example, maintain for 2 minutes to 60 minutes), where the first preset temperature is greater than 600°C;
decreasing the reaction temperature from the first preset temperature to a second preset temperature at a rate greater than 2°C/min, where the second preset temperature is less than the first preset temperature and greater than 600°C.
decreasing the reaction temperature from the second preset temperature to a third preset temperature at a rate greater than 20°C/min, where the third preset temperature is less than 100°C.

In this way, in the annealing process, by rapidly increasing and decreasing the temperature, and setting a relatively high thermal annealing temperature, that is, setting the thermal annealing temperature as the first preset temperature, fast movement and diffusion of the hydrogen in the first tunnel oxide layer 10 and the polysilicon doped conductive layer 30 can be achieved, which can assist the first tunnel oxide layer 10 to achieve better surface passivation, discharge excess hydrogen from the first tunnel oxide layer 10 and the polysilicon doped conductive layer 30, and form the holes 50 in the polysilicon doped conductive layer 30.

The first preset temperature may be in a range from 850°C to 990°C.

Further, the step of forming the amorphous silicon doped material layer 304 in step S111 includes:
sequentially forming and laminating a first amorphous silicon material layer 3041 and a second amorphous silicon material layer 3042 on a surface of the first tunnel oxide material layer 11 that is away from the substrate 40, where an effective electroactive doping concentration of the first amorphous silicon material layer 3041 is less than an effective electroactive doping concentration of the second amorphous silicon material layer 3042.

In this way, on the one hand, the first amorphous silicon material layer 3041 can alleviate the impact on the first tunnel oxide layer 10 brought by crystallizing the dopant in the second amorphous silicon material layer 3042 during high temperature annealing. On the other hand, the undoped or low-concentration doped first amorphous silicon material layer 3041 has a higher hydrogen content, and thus may provide more hydrogen, thereby assisting the first tunnel oxide layer 10 to achieve better surface passivation.

The inventors of the present application have also tested the solution in which the polysilicon doped conductive layer 30 is formed by the first amorphous silicon material layer 3041 and the second amorphous silicon material layer 3042. Compared with a solution in which a single-layer polysilicon doped conductive layer is formed, in the present application, the open circuit voltage Uoc is changed from 727 mV to 729 mV. It can be learned that the performance of the solar cell 200 manufactured by using the manufacturing method of the embodiments of the present application is improved to a certain extent.

In a specific implementation, the effective electroactive doping concentration of the first amorphous silicon material layer 3041 is less than 2E20cm⁻³, and the effective electroactive doping concentration of the second amorphous silicon material layer 3042 is greater than or equal to 2E20cm⁻³.

It is to be understood that the effective electroactive doping concentration of the first amorphous silicon material layer 3041 may be 0, that is, the first amorphous silicon material layer 3041 may be an intrinsic amorphous silicon material layer.

In an embodiment of the present application, for the removing the first oxide layer 305, and removing at least a part of regions of the first tunnel oxide layer 10 corresponding to the through holes 303 in a thickness direction of the first tunnel oxide layer 10, so as to define the holes 50 together with the corresponding through holes 303 in step S13, in a specific implementation, it can be implemented by washing with an acid solution including HF. Certainly, in step S13, if a second oxide layer is formed on the doped conductive layer 60 on the second surface S of the substrate 40, then the second oxide layer may also be simultaneously removed.

In an embodiment of the present application, referring to FIG. 9, the step of forming the second tunnel oxide layer 20 on the surface of the polysilicon doped conductive layer 30 that is away from the first tunnel oxide layer 10 in step S20 includes:
forming the second tunnel oxide layer 20 on the surface of the polysilicon doped conductive layer 30 that is away from the first tunnel oxide layer 10, and the second tunnel oxide layer 20 fully filling the holes 50.

Further, referring to FIG. 10, the manufacturing method further includes: before the step of sequentially forming and laminating the first tunnel oxide layer 10 and the polysilicon doped conductive layer 30 on the surface of the substrate 40 in step S10,
performing etching processing on the first surface F of the substrate 40, such that a reflectivity of the first surface F is greater than 30%, and/or, performing etching processing on the first surface F of the substrate 40, such that a roughness of the first surface F of the substrate 40 is less than 1 µm; where the first surface F is a surface of the substrate 40 on which the first tunnel oxide layer 10 is to be formed.

In this way, the first surface F of the substrate 40 can have fewer silicon substrate flaws, thereby easily obtaining a better surface passivation effect.

Further, the step of performing etching processing on the first surface F of the substrate 40 includes:
forming a doped conductive material layer on the second surface S of the substrate 40. In a case in which the doped conductive layer is P-type and doped with a boron element, for example, the doped conductive material layer may be formed by performing boron diffusion on the second surface S of the substrate 40.

The doped conductive material layer plated around each of the side surfaces and the first surface F of the substrate 40 is removed by etching, to form a doped conductive layer 60 on the second surface S of the substrate 40, as shown in FIG. 4. It should be noted herein that the doped conductive layer 60 herein is configured to form a PN junction with the substrate 40, and a doping type of the doped conductive layer 60 is opposite to that of the polysilicon doped conductive layer 30.

Further, referring to FIG. 10, the manufacturing method further includes: after the step of forming the second tunnel oxide layer 20 on the surface of the polysilicon doped conductive layer 30 that is away from the first tunnel oxide layer 10 in step S20,
forming a second passivation film layer 80 on a surface of the doped conductive layer 60 that is away from the substrate 40; and
forming a first passivation film layer 70 on a surface of the second tunnel oxide layer 20 that is away from the substrate 40.

A specific example illustrating the manufacturing method of the solar cell according to an embodiment of the present application is provided below. The manufacturing method includes step 1 to step 7:
At step 1, a substrate 40 is provided, and a doped conductive material layer is formed on a second surface S of the substrate 40, and simultaneously, the doped conductive material layer is also plated around a first surface F and each of the side surfaces of the substrate 40.
At Step 2, referring to FIG. 4, the doped conductive material layer plated around each of the side surfaces and the first surface F of the substrate 40 are removed by etching, to form a doped conductive layer 60 on the second surface S of the substrate 40; and the first surface F of the substrate 40 is formed as a smooth and flat surface having polishing morphology, where, a reflectivity of the first surface F is greater than 30%, or a roughness of the first surface F is less than 1 µm.
At step 3, a first tunnel oxide material layer 11, a first amorphous silicon material layer 3041, a second amorphous silicon material layer 3042, and a first oxide material layer 302 are sequentially formed on the first surface F of the substrate 40. Simultaneously, the first tunnel oxide material layer 11, the first amorphous silicon material layer 3041, the second amorphous silicon material layer 3042, and the first oxide material layer 302 are also formed on the second surface S and each of the side surfaces of the substrate 40.

The step of forming the first tunnel oxide material layer 11 includes: introducing an oxygen source at a temperature of 300°C or higher. The oxygen source may be, for example, N₂O, CO, CO₂, or the like. The oxygen source is ionized under a microwave power supply to generate oxygen ions. The oxygen ions react with the surface of the substrate 40 to form an ultra-thin first tunnel oxide material layer 11, which have a thickness in a range from 0.5 nm to 5 nm.

The step of forming the first amorphous silicon material layer 3041 includes: introducing silane and hydrogen in a first ratio, or silane and argon in a first ratio; and depositing and growing a hydrogen-rich intrinsic amorphous silicon layer as the first amorphous silicon material layer 3041 under the action of a microwave power supply. Alternatively, silane, phosphane and hydrogen in a first ratio are introduced, or silane, phosphoane and argon in a first ratio are introduced, and under the action of the microwave power supply, a hydrogen-rich lightly doped amorphous silicon layer is deposited and grew as the first amorphous silicon material layer 3041.

The step of forming the second amorphous silicon material layer 3042 includes: introducing silane and phosphane in a second ratio different from the first ration, in which the ratio of phosphane to silane is greater than that of the first amorphous silicon material layer 3041, and depositing and growing a doped amorphous silicon layer with a higher doping concentration as the second amorphous silicon material layer 3042.

At Step 4, at a temperature of 800°C or higher, annealing processing is performed on the structure body formed in Step 3, such that the first tunnel oxide material layer 11, the first amorphous silicon material layer 3041, and the second amorphous silicon material layer 3042 are crystallized, and transformed into a polysilicon doped material layer 301, that is, a first polysilicon doped material layer and a second polysilicon doped material layer. Simultaneously, an excess part of hydrogen on the surface of the first tunnel oxide material layer 11 escapes, forming through holes 303 each having a size of 100 nm or larger in the polysilicon doped material layer 301 and the first oxide material layer 302. As such, regions of the first tunnel oxide material layer 11 corresponding to the through holes 303 are exposed, thereby forming a structure shown in FIG. 5.

At Step 5, the first tunnel oxide material layer 11, the polysilicon doped material layer 301, and the first oxide material layer 302 that are plated around the second surface S of the substrate 40 and each of the side surfaces of the substrate 40 are removed, to sequentially form the first tunnel oxide layer 10, the polysilicon doped conductive layer 30 (that is, a first polysilicon doped conductive layer 31 and a second polysilicon doped conductive layer 32), and the first oxide layer 305 on the first surface F of the substrate 40. The first oxide layer 305 is removed, and at least a part of regions of the first tunnel oxide layer 10 corresponding to the through holes 303 is removed in the thickness direction of the first tunnel oxide layer 10, so as to define the holes 50 together with the corresponding through holes 303. The obtained structure body is shown in FIG. 6, and the structures of the holes 50 are shown in FIGS. 7 and 8.

At Step 6, a second tunnel oxide layer 20 is formed on the polysilicon doped conductive layer 30 by using plasma enhanced chemical vapor deposition (PECVD). The second tunnel oxide layer 20 fills the holes 50. A range of thickness of the second tunnel oxide layer 20 is consistent with that of the first tunnel oxide layer 10, as shown in FIG. 9.

At Step 7, referring to FIG. 10, a second passivation film layer 80 is formed on a surface of the doped conductive layer 60 facing away from the substrate 40; a first passivation film layer 70 is formed on a surface of the second tunnel oxide layer 20 facing away from the substrate 40; and a first electrode 91 and a second electrode 92 are formed respectively on the first passivation film layer 70 and the second passivation film layer 80. The first passivation film layer 70 and the second passivation film layer 80 may be made of materials including aluminium oxide, silicon nitride, silicon oxynitride, silicon oxide, or the like.

In the solar cell 200 manufactured by using the manufacturing method of the embodiments of the present application, since more hydrogen is supplied to passivate the surface of the substrate 40, a sufficient passivation effect can be achieved. In addition, the second tunnel oxide layer 20 is deposited on the surface of the polysilicon doped conductive layer 30 on which excessive hydrogen escapes. The polysilicon doped conductive layer 30 includes holes 50, which can improve and compensate for surface passivation quality. Compared with a hole-free structure, in the present application, the surface passivation quality can be improved, the surface recombination can be reduced, and the conversion efficiency of the solar cell 200 can be improved.

A third aspect of embodiments of the present application provides a photovoltaic module (not shown in the figure). The photovoltaic module includes at least one cell string. The cell string includes at least two solar cells 200 described above. The solar cells 200 may be connected together by series welding.

A fourth aspect of embodiments of the present application provides a photovoltaic system (not shown). The photovoltaic system includes the foregoing photovoltaic module.

The photovoltaic system may be applied to a photovoltaic power station, such as a ground-mounted power station, a roof-mounted power station, a water-on-power station, or the like, or may be applied to a device or an apparatus that generates power by using solar energy, such as a user solar power supply, a solar street lamp, a solar vehicle, a solar building, or the like. Certainly, it is to be understood that the application scenarios of the photovoltaic system are not limited thereto. In other words, the photovoltaic system may be applied to all fields in which solar energy needs to be used for generating power. Taking the photovoltaic power generation system network as an example, the photovoltaic system may include photovoltaic arrays, combiner boxes, and inverters. The photovoltaic array may be an array combination of a plurality of photovoltaic modules. For example, the plurality of photovoltaic modules may form a plurality of photovoltaic arrays. The photovoltaic arrays are connected to combiner boxes. The combiner boxes may combine the current generated by the photovoltaic arrays. The combined current flows through the inverters and is converted into an alternating current required by a mains power network, and is then input to the mains power network to implement solar power supply.

The technical features of the above embodiments can be combined arbitrarily. In order to make the description concise, not all possible combinations of the technical features in the above embodiments are described. However, as long as there is no contradiction in the combination of these technical features, all should be considered as the scope described in this specification.

The above described embodiments merely illustrate several embodiments of the present application, which are described more specifically and in detail, but they cannot be understood as limiting the scope of the present application. It should be noted that, for those ordinary skilled in the art, several variants and improvements may be made without departing from the concept of the present application, and all of which are within the protection scope of the present application. Therefore, the scope of protection of the present application shall be subject to the appended claims.

## Claims

1. A solar cell (200), comprising a substrate (40) and a passivated contact structure (100);
the passivated contact structure (100) comprising a first tunnel oxide layer (10), a polysilicon doped conductive layer (30), and a second tunnel oxide layer (20) sequentially disposed on a surface of the substrate (40);
wherein, a plurality of holes (50) arranged spaced apart from each other are formed in at least a part of regions of the polysilicon doped conductive layer (30) and the first tunnel oxide layer (10); and each of the holes (50) extends through the polysilicon doped conductive layer (30) and extends into the first tunnel oxide layer (10); and
the second tunnel oxide layer (20) at least fills a portion of each of the holes (50) that is located within the first tunnel oxide layer (10).

2. The solar cell (200) of claim 1, wherein the second tunnel oxide layer (20) fully fills each of the holes (50);
optionally, wherein at least a part of the holes (50) extends through the first tunnel oxide layer (10).

3. The solar cell (200) of claim 1, wherein each of the holes (50) has a cross-sectional profile in a circular shape, and each of the holes (50) has a diameter being greater than or equal to 100 nm; or
each of the holes (50) has a cross-sectional profile in a shape of polygon, and a length of at least one edge of the polygon is greater than or equal to 100 nm.

4. The solar cell (200) of claim 1, wherein the first tunnel oxide layer (10) has a thickness being equal to a thickness of the second tunnel oxide layer (20); and/or
the first tunnel oxide layer (10) is made of a same material as the second tunnel oxide layer (20); and/or
the second tunnel oxide layer (20) has a thickness in a range from 0.5 nm to 5 nm.

5. The solar cell (200) of any one of claims 1 to 4, wherein the polysilicon doped conductive layer (30) comprises a first polysilicon doped conductive layer (31) and a second polysilicon doped conductive layer (32) that are laminated;
the first polysilicon doped conductive layer (31) is adjacent to the first tunnel oxide layer (10), and the second polysilicon doped conductive layer (32) is adjacent to the second tunnel oxide layer (20); and
a doping concentration of the first polysilicon doped conductive layer (31) is lower than a doping concentration of the second polysilicon doped conductive layer (32).

6. The solar cell (200) of any one of claims 1 to 4, wherein a first surface (F) of the substrate (40) has a reflectivity being greater than 30%;
and optionally the first surface (F) of the substrate (40) has a roughness being less than 1 µm; and the first surface (F) is a surface of the substrate (40) on which the first tunnel oxide layer (10) is disposed;
and more optionally the solar cell (200) further comprises:
a first passivation film layer (70) laminated on a surface of the second tunnel oxide layer (20) that is away from the substrate (40); and
a doped conductive layer (60) and a second passivation film layer (80), sequentially laminated on a surface of the substrate (40) that is away from the first tunnel oxide layer (10);
and even more optionally the first passivation film layer has a single-layer or multi-layer structure; and the first passivation film layer is made of silicon oxide, silicon nitride, or silicon oxynitride.

7. A manufacturing method of a solar cell, comprising:
sequentially forming and laminating a first tunnel oxide layer (10) and a polysilicon doped conductive layer (30) on a surface of the substrate (40); wherein, a plurality of holes (50) arranged spaced apart from each other are formed in at least a part of regions of the polysilicon doped conductive layer (30) and the first tunnel oxide layer (10), and each of the holes (50) extends through the polysilicon doped conductive layer (30) and extends into the first tunnel oxide layer (10); and
forming a second tunnel oxide layer (20) on a surface of the polysilicon doped conductive layer that (30) is away from the first tunnel oxide layer (10), and the second tunnel oxide layer (20) at least filling a portion of each of the holes (50) that is located within the first tunnel oxide layer (10).

8. The manufacturing method of claim 7, wherein the sequentially forming and laminating the first tunnel oxide layer (10) and the polysilicon doped conductive layer (30) on the surface of the substrate (40) comprises:
sequentially forming a first tunnel oxide material layer (11), a polysilicon doped material layer (301), and a first oxide material layer (302) on a first surface (F) of the substrate (40), wherein a plurality of through holes (303) are formed in the polysilicon doped material layer (301) and the first oxide material layer (302), such that regions of the first tunnel oxide material layer (11) corresponding to the through holes (303) are exposed; and
removing the first tunnel oxide material layer (11), the polysilicon doped material layer (301), and the first oxide material layer (302) that are plated around a second surface (S) of the substrate (40) and each of side surfaces of the substrate (40), to sequentially form the first tunnel oxide layer (10), the polysilicon doped conductive layer (30), and a first oxide layer (305) on the first surface (F) of the substrate (40); wherein the first surface (F) and the second surface (S) are arranged opposite to each other, and each of the side surfaces of the substrate (40) is adjacent to and located between the first surface (F) and the second surface (S); and
removing the first oxide layer (305), and removing at least a part of regions of the first tunnel oxide layer (10) corresponding to the through holes (303) in a thickness direction of the first tunnel oxide layer (10), so as to define the holes (50) together with the corresponding through holes (303).

9. The manufacturing method of claim 8, wherein the sequentially forming the first tunnel oxide material layer (11), the polysilicon doped material layer (301), and the first oxide material layer (302) on the first surface (F) of the substrate (40) comprises:
sequentially forming the first tunnel oxide material layer (11), an amorphous silicon doped material layer (304), and the first oxide material layer (302) on the first surface (F) of the substrate (40); and
performing an annealing process to transform the amorphous silicon doped material layer (304) into the polysilicon doped material layer (301), and forming the plurality of through holes (303) in the polysilicon doped material layer (301) and the first oxide material layer (302).

10. The manufacturing method of claim 9, wherein a process condition of the annealing process comprises:
increasing a reaction temperature from 25°C to a first preset temperature at a rate greater than 5°C/min, and maintaining for a preset time period, wherein the first preset temperature is greater than 600°C;
decreasing the reaction temperature from the first preset temperature to a second preset temperature at a rate greater than 2°C/min, wherein the second preset temperature is less than the first preset temperature and greater than 600°C; and
decreasing the reaction temperature from the second preset temperature to a third preset temperature at a rate greater than 20°C/min, wherein the third preset temperature is less than 100°C.

11. The manufacturing method of claim 9, wherein the forming the amorphous silicon doped material layer (304) comprises:
sequentially forming and laminating a first amorphous silicon material layer (3041) and a second amorphous silicon material layer (3042) on a surface of the first tunnel oxide material layer (11) that is away from the substrate (40), wherein an effective electroactive doping concentration of the first amorphous silicon material layer (3041) is less than an effective electroactive doping concentration of the second amorphous silicon material layer (3042);
optionally, wherein the effective electroactive doping concentration of the first amorphous silicon material layer (3041) is less than 2E20cm⁻³, and the effective electroactive doping concentration of the second amorphous silicon material layer (3042) is greater than or equal to 2E20cm⁻³.

12. The manufacturing method of claim 7, wherein the forming the second tunnel oxide layer (20) on the surface of the polysilicon doped conductive layer (30) that is away from the first tunnel oxide layer (10) comprises:
forming the second tunnel oxide layer (20) on the surface of the polysilicon doped conductive layer (30) that is away from the first tunnel oxide layer (10), and the second tunnel oxide layer (20) fully filling the holes (50);
and/or, the manufacturing method, further comprises: before the sequentially forming and laminating the first tunnel oxide layer (10) and the polysilicon doped conductive layer (30) on the surface of the substrate (40),
performing etching processing on a first surface (F) of the substrate (40), such that a reflectivity of the first surface (F) is greater than 30%; and/or
performing etching processing on the first surface (F) of the substrate (40), such that a roughness of the first surface (F) of the substrate (40) is less than 1 µm;
wherein the first surface (F) is a surface of the substrate (40) on which the first tunnel oxide layer (10) is disposed.

13. The manufacturing method of claim 12, further comprising: after the forming the second tunnel oxide layer (20) on the surface of the polysilicon doped conductive layer (30) that is away from the first tunnel oxide layer (10),
forming a first passivation film layer (70) on a surface of the second tunnel oxide layer (20) that is away from the substrate (40).

14. A photovoltaic module, comprising at least one cell string, the cell string comprising at least two solar cells (200) of any one of claims 1 to 6.

15. A photovoltaic system, comprising the photovoltaic module of claim 14.
